# EUROPEAN PATENT APPLICATION

(11) **EP 4 757 550 A1**
(43) Date of publication of application: **10.06.2026**
(21) Application number: 25164006.6
(22) Date of filing: 16.03.2025
(51) Int. Cl.: H10H 29/14, H10H 29/01, H10H 20/819, H10H 20/825, H10H 29/80, H10H 29/85, H10H 29/855

(54) **GAN-BASED MULTI-LIGHT-ZONE LED CHIP, LIGHT SOURCE MODULE WITH THE SAME, AND PREPARATION METHOD THEREOF**

(30) Priority: 04.12.2024 CN 202411772246
(71) Applicant: Nitelab Optoelectronics Co., Ltd., Foshan, Guangdong 528251 (CN)
(72) Inventor: LI, Wenjie, Foshan, Guangdong, 528251 (CN)
(74) Representative: KIPA AB

(57) **Abstract**

A GaN-based multi-light-zone LED chip, a light source module and a preparation method are provided. The multi-zone LED chip includes: a substrate (100) and a GaN-based light-emitting body (200) disposed on the substrate. The body (200) is provided with at least one annular isolation trench (201) extending through top and bottom surfaces of the body. When a plurality of annular isolation trenches (201) are provided, contours of orthogonal projections of the plural trenches onto the substrate (100) gradually decrease in size, and the plural trenches are progressively nested from inside to outside. The zone adjacent to the sidewall of any annular isolation trench on the GaN-based light-emitting body is a sub-light-emitting zone (202). When each of the sub-light-emitting zones is illuminated, a light beam is emitted correspondingly at a specific angle, therefore, the different sub-light-emitting zones can be illuminated to perform a beam transformation, achieving the beam transformation through the GaN-based multi-light-zone LED chip. This results in a simpler structure, reducing costs of a light source module and decreasing size and weight.

## Description

### BACKGROUND

In mobile lighting, to meet more diverse lighting requirements, light source modules often have the capability to perform beam transformation, that is, by switching to different beams to satisfy various lighting needs.

At present, when performing light beam transformation in a light source module, one method is to enable a distance between a lens and a light source in the light source module to be changed, and the light beam transformation is achieved by changing the distance between the lens and the light source in the light source module when performing the light beam transformation; another method is to dispose a plurality of LED light sources at different positions on a same focal plane in the light source, and when performing the light beam transformation, the light beam transformation is achieved by driving the LED light sources at different positions on the same focal plane; in the above two methods, although the light beam transformation can be performed, the structures are complicated, which makes the cost of the light source module high, and the volume and weight of the light source module large.

Therefore, the prior art still requires improvement and development.

### SUMMARY

In view of the shortcomings of the aforementioned prior art, the objective of the present disclosure is to provide a GaN-based multi-light-zone LED chip, a light source module, and a preparation method thereof, to solve the issues in the prior art where the methods used for beam transformation in light source modules are structurally complex, leading to high costs and larger size and weight of the light source modules.

The technical solution adopted by the present disclosure to solve the technical problems is: to provide a GaN-based multi-light-zone LED chip, including: a substrate and a GaN-based light-emitting body disposed on the substrate;

the GaN-based light-emitting body is provided with at least one annular isolation trench extending through a top surface and a bottom surface of the GaN-based light-emitting body, and when a plurality of annular isolation trenches are provided, contours of orthogonal projections of the plurality of annular isolation trenches onto the substrate gradually decrease in size, and the plurality of annular isolation trenches are progressively nested from inside to outside;

a zone adjacent to sidewall of any annular isolation trench on the GaN-based light-emitting body is a sub-light-emitting zone. When each of the sub-light-emitting zones is illuminated, a beam of light is emitted correspondingly at a specific angle.

The present disclosure further includes the following configuration, the GaN-based light-emitting body includes: metal electrodes, as well as, an N-type gallium nitride layer, a multiple quantum well layer, a P-type gallium nitride layer, and a transparent conductive layer, disposed on the substrate from bottom to top;

a top surface of the transparent conductive layer is the top surface of the GaN-based light-emitting body, and a bottom surface of the N-type gallium nitride layer is the bottom surface of the GaN-based light-emitting body;

a positive electrode of the metal electrodes is connected to the transparent conductive layer, and a negative electrode of the metal electrodes is connected to the N-type gallium nitride layer.

The present disclosure further includes the following configuration, when one annular isolation trench is provided, a light power density of the sub-light-emitting zone adjacent to an inner sidewall of the annular isolation trench is highest.

The present disclosure further includes the following configuration, when the plurality of annular isolation trenches are provided, the light power density of the sub-light-emitting zone adjacent to the inner sidewall of an innermost annular isolation trench is highest.

The present disclosure further includes the following configuration, when the plurality of annular isolation trenches are provided, the light power density of the sub-light-emitting zone decreases gradually from inside to outside.

The present disclosure further includes the following configuration, the sub-light-emitting zone with the highest light power density among the sub-light-emitting zones has a light power density greater than 6 A/mm².

The present disclosure further includes the following configuration, the annular isolation trench is either circular annular isolation trenches or polygonal annular isolation trenches.

The present disclosure further provides a light source module, including: a housing with an accommodation chamber, and the GaN-based multi-light-zone LED chip as described above.

The present disclosure further includes the following configuration, the light source module includes a positive lens, in which the positive lens is disposed on the housing and a light emitted from the GaN-based multi-light-zone LED chip passes through the positive lens.

The present disclosure further provides a preparing method for the GaN-based multi-light-zone LED chip, including:

providing a substrate;

growing a GaN-based light-emitting body on the substrate;

providing an annular isolation trench in the GaN-based light-emitting body, wherein the annular isolation trench penetrate through a top surface and a bottom surface of the GaN-based light-emitting body, and when a plurality of annular isolation trenches are provided, contours of orthogonal projections onto the substrate gradually decrease in size and are nested from inside to outside.

Beneficial effects of the present disclosure:

A GaN-based multi-light-zone LED chip, a light source module and a preparation method are provided, including: a substrate and a GaN-based light-emitting body disposed on the substrate; the GaN-based light-emitting body is provided with at least one annular isolation trench extending through a top surface and a bottom surface of the GaN-based light-emitting body, and when a plurality of annular isolation trenches are provided, contours of orthogonal projections of the plurality of annular isolation trenches onto the substrate gradually decrease in size, and the plurality of annular isolation trenches are progressively nested from inside to outside; the zone adjacent to the sidewall of any of the annular isolation trench on the GaN-based light-emitting body is the sub-light-emitting zone, when each of the sub-light-emitting zones is illuminated, a beam of light is emitted correspondingly at a specific angle. In the technical solution of the present disclosure, the GaN-based light-emitting body includes at least the one annular isolation trench, the zone adjacent to the sidewall of any of the annular isolation trench on the GaN-based light-emitting body is a sub-light-emitting zone, when each of the sub-light-emitting zones is illuminated, the beam of light is emitted correspondingly at the specific angle. Therefore, different sub-light-emitting zones can be illuminated to perform beam transformation, achieving the beam transformation through the GaN-based multi-light-zone LED chip. This results in a simpler structure, reducing the cost of the light source module and decreasing the size and weight.

### BRIEF DESCRIPTION OF THE DRAWINGS

In order to more clearly illustrate the embodiments of the present disclosure or the technical solutions in the prior art, the drawings required for use in the embodiments or the description of the prior art are briefly introduced below. Obviously, the drawings described below are only some embodiments recorded in the present application. For those skilled in the art, other drawings can be obtained based on these drawings without involving creative work.
FIG. 1 is a top view of a GaN-based multi-light-zone LED chip of the present disclosure.
FIG. 2 is a flow chart of a preparation method for the GaN-based multi-light-zone LED chip of the present disclosure.

In the drawings, the reference numerals are: 100-substrate; 200-GaN-based light-emitting body; 201-annular isolation trench; 202-sub-light-emitting zone; 203-metal electrode.

### DETAILED DESCRIPTION OF EMBODIMENTS

In order to have a clearer understanding of the technical features, objectives, and effects of the present disclosure, the specific embodiments of the present disclosure are described in detail with reference to the accompanying drawings. In the following description, it should be understood that the directional or positional relationships indicated by terms such as "front", "back", "up", "down", "left", "right", "longitudinal", "horizontal", "vertical", "horizontal", "top", "bottom", "inside", "outside", "head", "tail", etc., based on the directions or positional relationships shown in the accompanying drawings, are constructed and operated in a specific direction, and are only for the convenience of describing the present technical solution, rather than indicating that the device or element referred to must have a specific direction, and therefore cannot be understood as a limitation to the present disclosure.

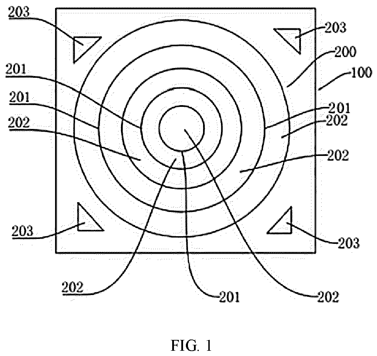

As shown in FIG. 1, the present disclosure provides a GaN-based multi-light-zone LED chip, which includes: a substrate 100 and a GaN-based light-emitting body 200 disposed on the substrate 100; the GaN-based light-emitting body 200 is provided with at least one annular isolation trench 201 extending through a top surface and a bottom surface of the GaN-based light-emitting body 200, and when a plurality of annular isolation trenches 201 are provided, contours of orthogonal projections of the plurality of annular isolation trenches 201 onto the substrate 100 gradually decrease in size, and the plurality of annular isolation trenches 201 are progressively nested from inside to outside; a zone adjacent to sidewall of any of the annular isolation trench 201 on the GaN-based light-emitting body 200 is a sub-light-emitting zone 202, when each of the sub-light-emitting zones 202 is illuminated, a beam of light is emitted correspondingly at a specific angle.

When configuring the annular isolation trench 201, a laser or ion etching method is used to etch a ring-shaped trench that penetrates through the top surface and the bottom surface of the GaN-based light-emitting body 200, that is, the annular isolation trench 201 that penetrates through the top surface and bottom surface of the GaN-based light-emitting body 200. The annular isolation trench 201 forms the plurality of sub-light-emitting zones 202 in the GaN-based light-emitting body 200, where a specific number of the sub-light-emitting zones 202 formed is related to the number of the annular isolation trenches 201 provided. For example, when one annular isolation trench 201 is provided, the GaN-based light-emitting body 200 forms two sub-light-emitting zones 202, which are the two zones adjacent to the sidewall of the annular isolation trench 201; for another example, when two annular isolation trenches 201 are provided, the GaN-based light-emitting body 200 forms three sub-light-emitting zones 202, which are the two zones adjacent to the sidewall of the innermost annular isolation trench 201 and the zone adjacent to the sidewall of the outermost annular isolation trench 201 (the innermost and the outermost annular isolation trenches 201 share a common adjacent zone, and the shared adjacent zone of the two annular isolation trenches 201 forms one sub-light-emitting zone 202)." Therefore, when the two annular isolation trenches 201 are provided, the GaN-based light-emitting body 200 forms the three sub-light-emitting zones 202. Among them, the purpose of configuring the annular isolation trench 201 to penetrate through the top surface and the bottom surface of the GaN-based light-emitting body 200 is to allow each of the sub-light-emitting zones 202 to be independently illuminated.

It should be noted that the walls of the annular isolation trench 201 include both the inner wall and the outer wall of the trench.

In the present embodiment, the GaN-based light emitter 200 is arranged with at least the one annular isolation trench 201. The zone adjacent to the sidewall of any of the annular isolation trench 201 on the GaN-based light-emitting body 200 is the sub-light-emitting zone 202, when each of the sub-light-emitting zones is illuminated, the beam of light is emitted correspondingly at the specific angle, therefore, the different sub-light-emitting zones can be illuminated to perform beam transformation, achieving the beam transformation through the GaN-based multi-light-zone LED chip. This results in the simpler structure, reducing the cost of the light source module and decreasing the size and weight.

In some embodiments, the GaN-based light-emitting body 200 includes metal electrodes 203, as well as, an N-type gallium nitride layer, a multiple quantum well layer, a P-type gallium nitride layer, and a transparent conductive layer, which are deposited on the substrate 100 from bottom to top; in which a top surface of the transparent conductive layer is the top surface of the GaN-based light-emitting body 200, and a bottom surface of the N-type gallium nitride layer is the bottom surface of the GaN-based light-emitting body 200; in which a positive electrode of the metal electrodes 203 is connected to the transparent conductive layer, and a negative electrode of the metal electrodes 203 is connected to the N-type gallium nitride layer.

The substrate 100 can be a sapphire substrate 100. On the sapphire substrate 100, the N-type gallium nitride layer, the multiple quantum well layer, the P-type gallium nitride layer, and the transparent conductive layer are sequentially grown using MOCVD (Metal-Organic Chemical Vapor Deposition) technology. Among them, when configuring the annular isolation trench 201, the annular isolation trench 201 penetrates from the top surface of the transparent conductive layer to the bottom surface of the N-type gallium nitride layer.

Furthermore, when configuring the metal electrodes 203, a preparation employs an evaporation of a metal film method. The metal electrodes 203 include the positive electrode and the negative electrode. The metal electrodes 203 can be prepared in any of the zone on the GaN-based multi-light LED chip that does not interfere with normal operation. For example, the metal electrodes 203 can be placed on a bottom of the substrate 100 (a side opposite to the N-type gallium nitride layer) or on the same side of the substrate 100 as the N-type gallium nitride layer. Skilled persons in the field determine the specific preparation location based on actual conditions, without imposing undue restrictions.

Furthermore, when preparing the metal electrodes 203, one option is to dispose a set of the positive and negative electrodes for each of the sub-light-emitting zones 202, or to have all of the sub-light-emitting zones 202 share a common negative electrode while configuring a separate positive electrode for each of the sub-light-emitting zones 202. Under the condition that each of the sub-light-emitting zones 202 can be independently illuminated, those skilled in the art determine the specific configuration of the positive and negative electrodes in the metal electrodes 203 based on the actual conditions, without imposing undue restrictions.

In the embodiment, the positive electrode is connected to the transparent conductive layer, and the negative electrode is connected to the N-type gallium nitride layer.

In some embodiments, when one annular isolation trench is provided, a light power density of the sub-light-emitting zone 202 adjacent to an inner sidewall of the annular isolation trench is the highest.

In the present embodiment, since the sub-light-emitting zone 202 with the highest light power density is adjacent to the inner wall of the annular isolation trench, when it is necessary to illuminate a distant target with a smaller field of view angle in front, the sub-light-emitting zone 202 with the highest light power density can be illuminated, to emit a beam of light with a smaller field of view angle to illuminate the target.

In some embodiments, when the plurality of the annular isolation trenches are provided, the light power density of the sub-light-emitting zone 202 adjacent to the inner wall of the innermost annular isolation trench is the highest.

In the present embodiment, since the sub-light-emitting zone 202 with the highest light power density is adjacent to the inner wall of the innermost annular isolation trench, when it is necessary to illuminate the distant target with a smaller field of view angle in front, the sub-light-emitting zone 202 with the highest light power density can be illuminated, to emit the beam of light with the smaller field of view angle to illuminate the target.

Furthermore, when the plurality of annular isolation trenches are provided, the light power density of the sub-light-emitting zones 202 decreases gradually from the innermost to the outermost zones.

In the present embodiment, since each of the sub-light-emitting zones 202 is illuminated, the beam of light is emitted correspondingly at the specific angle, under the condition that the light power density decreases gradually from the innermost to the outermost sub-light-emitting zones 202, illuminating the different sub-light-emitting zones 202 results in beams of light with different brightness levels and angles.

Furthermore, the light power density of the sub-light-emitting zone 202 with the highest light power density among the sub-light-emitting zones 202 is greater than 6 A/mm².

The light power density of the sub-light-emitting zone 202 with the highest light power density among the sub-light-emitting zones 202 can be 6.5 A/mm², 7 A/mm², 9 A/mm², 12 A/mm², etc. Skilled persons in the field can determine the sub-light-emitting zone 202 with the highest light power density based on the actual conditions, without imposing undue restrictions.

In some embodiments, when configuring the annular isolation trench 201, it can be formed as a circular annular isolation trench or a polygonal annular isolation trench.

In the present embodiment, as shown in FIG. 1, the annular isolation trench 201 can be formed as circular rings. When the plurality of annular isolation trenches 201 are provided, the inner diameter of the circular rings increases gradually from the innermost to the outermost.

The annular isolation trench 201 can also be formed as a square ring, an equilateral triangular ring, or a rhombic ring.

Therefore, when configuring the annular isolation trench 201 on the GaN-based light-emitting body 200, it can be disposed according to actual needs, thereby broadening the applicability of the GaN-based multi-light LED chip.

In some embodiments, the present disclosure further provides a light source module that includes a housing with an accommodation chamber and the aforementioned GaN-based multi-light-zone LED chip.

The GaN-based multi-light-zone LED chip includes: the substrate 100 and the GaN-based light-emitting body 200 disposed on the substrate 100; the GaN-based light-emitting body 200 is provided with at least the one the annular isolation trench 201 extending through the top surface and the bottom surface of the GaN-based light-emitting body 200, and when the plurality of annular isolation trenches 201 are provided, the contours of the orthogonal projections of the plurality of annular isolation trenches 201 onto the substrate 100 gradually decrease in size, and the plurality of annular isolation trenches 201 are progressively nested from inside to outside; the zone adjacent to the sidewall of any of the annular isolation trenches 201 on the GaN-based light-emitting body 200 is the sub-light-emitting zone 202, when each of the sub-light-emitting zones 202 is illuminated, the beam of light is emitted correspondingly at the specific angle.

When configuring the annular isolation trench 201, the laser or ion etching method is used to etch the ring-shaped groove that penetrates through the top surface and the bottom surface of the GaN-based light-emitting body 200, that is, the annular isolation trench 201 that penetrates through the top surface and the bottom surface of the GaN-based light-emitting body 200. The annular isolation trench 201 forms the plurality of sub-light-emitting zones 202 in the GaN-based light-emitting body 200, where the specific number of the sub-light-emitting zones 202 formed is related to the number of the annular isolation trenches 201 provided. For example, when the one annular isolation trench 201 is provided, the GaN-based light-emitting body 200 forms the two sub-light-emitting zones 202, which are the two zones adjacent to the sidewalls of the annular isolation trench 201; for another example, when the two annular isolation trenches 201 are provided, the GaN-based light-emitting body 200 forms the three sub-light-emitting zones 202, which are the two zones adjacent to the sidewalls of the innermost annular isolation trench 201 and the zone adjacent to the sidewall of the outermost annular isolation trench 201 (the innermost and outermost annular isolation trenches 201 share the common adjacent zone, and the shared adjacent zone of the two annular isolation trenches 201 forms the one sub-light-emitting zone 202). Therefore, when the two annular isolation trenches 201 are provided, the GaN-based light-emitting body 200 forms the three sub-light-emitting zones 202. Among them, the purpose of configuring the annular isolation trench 201 to penetrate through the top and the bottom surface of the GaN-based light-emitting body 200 is to allow each of the sub-light-emitting zones 202 to be independently illuminated.

It should be noted that the walls of the annular isolation trench 201 include both the inner wall and the outer wall of the annular isolation trench 201.

In the present embodiment, the GaN-based light emitter 200 is disposed with at least the one annular isolation trench 201. The zone adjacent to the sidewall of any of the annular isolation trenches 201 on the GaN-based light-emitting body 200 is the sub-light-emitting zone 202, when each of the sub-light-emitting zones 202 is illuminated, the beam of light is emitted correspondingly at the specific angle. Therefore, the different sub-light-emitting zones can be illuminated to perform the beam transformation, achieving the beam transformation through the GaN-based multi-light-zone LED chip. This results in the simpler structure, reducing the cost of the light source module and decreasing its size and weight.

Furthermore, a positive lens is disposed on the housing and a light emitted from the GaN-based multi-light-zone LED chip passes through the positive lens

In the present embodiment, when one annular isolation trench 201 is provided, the light power density of the sub-light-emitting zone 202 adjacent to the inner sidewall of the annular isolation trench is the highest. When the plurality of annular isolation trenches are provided, the light power density of the sub-light-emitting zone 202 adjacent to the inner wall of the innermost annular isolation trench is the highest. Among them, the highest light power density exceeds 6 A/mm² and can be values such as 6.5 A/mm², 7 A/mm², 9 A/mm², 12 A/mm², etc.. Skilled persons in the field can determine the specific sub-light-emitting zone 202 with the highest light power density based on the actual conditions, without imposing undue restrictions.

Since the sub-light-emitting zone 202 with the highest light power density is disposed on the innermost side of all the sub-light-emitting zones 202, whether the one annular isolation trench 201 or the plurality of annular isolation trenches are provided, when the sub-light-emitting zone 202 with the highest light power density is illuminated, it forms an emitted beam with the smallest emission angle and highest brightness. When using the light source module, for illuminating the distant target that requires a smaller field of view angle, activating the sub-light-emitting zone 202 with the highest light power density to emit the beam with the highest brightness and smallest emission angle. After passing through the positive lens, this beam forms a strong light that illuminates the distant target with small field of view angle. For illuminating closer targets with a larger field of view angle, different sub-light-emitting zones 202 can be activated based on the actual conditions to meet the illumination requirements. This allows the light source module using the GaN-based multi-wavelength LED chip to achieve both long-distance, high-brightness illumination and short-distance, wide-range illumination, providing optimal lighting effects and enabling beam transformation.

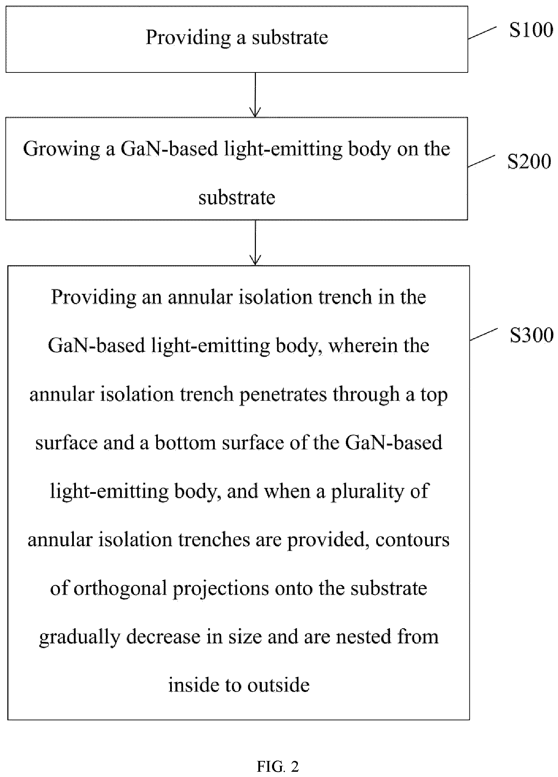

In some embodiments, as shown in FIG. 2, the present disclosure further provides a preparation method for the aforementioned GaN-based multi-light-zone LED chip, including:

S100: providing a substrate;

S200: growing a GaN-based light-emitting body on the substrate;

S300: providing an annular isolation trench in the GaN-based light-emitting body, in which the annular isolation trench penetrates through the top surface and bottom surface of the GaN-based light-emitting body, and when a plurality of annular isolation trenches are provided, contours of orthogonal projections onto the substrate gradually decrease in size and are nested from inside to outside.

The substrate can be the sapphire substrate. The GAN-based light-emitting body includes metal electrodes and an N-type gallium nitride layer, a multiple quantum well layer, a P-type gallium nitride layer, and a transparent conductive layer arranged on a substrate from bottom to top. On the sapphire substrate, the N-type gallium nitride layer, the multiple quantum well layer, the P-type gallium nitride layer, and the transparent conductive layer are sequentially grown using MOCVD (Metal-Organic Chemical Vapor Deposition) technology. Among them, when configuring the annular isolation trench 201, the annular isolation trench 201 penetrates from top surface of the transparent conductive layer to the bottom surface of the N-type gallium nitride layer. The metal electrodes are fabricated through the evaporation of the metal film.

When configuring the annular isolation trench, the laser or ion etching method is used to etch the ring-shaped groove that penetrates through the top surface and the bottom surface of the GaN-based light-emitting body, that is, the annular isolation trench that penetrates through the top surface and the bottom surface of the GaN-based light-emitting body. The annular isolation trench forms the plurality of sub-light-emitting zones in the GaN-based light-emitting body, where the specific number of the sub-light-emitting zones formed is related to the number of the annular isolation trenches provided.

In the present embodiment, the GaN-based light-emitting body includes at least the one annular isolation trench. The zone adjacent to the sidewall of any of the annular isolation trenches on the GaN-based light-emitting body is the sub-light-emitting zone, when each of the sub-light-emitting zones is illuminated, the beam of light is emitted correspondingly at the specific angle, therefore, the different sub-light-emitting zones can be illuminated to perform the beam transformation, achieving the beam transformation through the GaN-based multi-light-zone LED chip. This results in the simpler structure, reducing the cost of the light source module and decreasing the size and weight.

It should be noted that the descriptions of the embodiments of the light source module and the preparation method are similar to the aforementioned GaN-based multi-light-zone LED chip, offering similar benefits. For technical details not disclosed in the embodiments of the light source module and the preparation method thereof, please refer to the description of the embodiments of the GaN-based multi-light-zone LED chip for understanding.

In summary, the present disclosure provides the GaN-based multi-light-zone LED chip, the light source module, and the preparation method thereof, with the following beneficial effects:

The GaN-based light emitter 200 is disposed with at least the one annular isolation trench 201. The zone adjacent to the sidewall of any of the annular isolation trenches 201 on the GaN-based light-emitting body 200 is the sub-light-emitting zone 202, when each of the sub-light-emitting zones 202 is illuminated, a beam of light is emitted correspondingly at a specific angle. Therefore, the different sub-light-emitting zones can be illuminated to perform the beam transformation, achieving the beam transformation through the GaN-based multi-light-zone LED chip. This results in the simpler structure, reducing the cost of the light source module and decreasing the size and weight.

The above embodiments illustrate the preferred implementations of the present invention with detailed and specific descriptions. However, the descriptions should not be interpreted as limiting the scope of the patent protection for the invention. It is important to note that for those skilled in the art, it is possible to freely combine the described technical features and make various modifications and improvements without departing from the inventive concept. These modifications and improvements are all within the protection scope of the invention. Consequently, any equivalent transformations or modifications made to the claims of the present disclosure are encompassed within the scope of the claims.

## Claims

1. A GaN-based multi-light-zone LED chip, comprising: a substrate and a GaN-based light-emitting body disposed on the substrate;
the GaN-based light-emitting body is provided with at least one annular isolation trench extending through a top surface and a bottom surface of the GaN-based light-emitting body, and when a plurality of annular isolation trenches are provided, contours of orthogonal projections of the plurality of annular of isolation trenches onto the substrate gradually decrease in size, and the plurality of annular isolation trenches are progressively nested from inside to outside;
wherein a zone adjacent to a sidewall of any annular isolation trench on the GaN-based light-emitting body is a sub-light-emitting zone.

2. The GaN-based multi-light-zone LED chip according to claim 1, wherein the GaN-based light-emitting body comprises: metal electrodes, as well as, an N-type gallium nitride layer, a multiple quantum well layer, a P-type gallium nitride layer, and a transparent conductive layer disposed on the substrate from bottom to top;
wherein a top surface of the transparent conductive layer is the top surface of the GaN-based light-emitting body, and a bottom surface of the N-type gallium nitride layer is the bottom surface of the GaN-based light-emitting body;
wherein a positive electrode of the metal electrodes is connected to the transparent conductive layer, and a negative electrode of the metal electrodes is connected to the N-type gallium nitride layer.

3. The GaN-based multi-light-zone LED chip according to claim 1, wherein when one annular isolation trench is provided, a light power density of a sub-light-emitting zone adjacent to an inner sidewall of the annular isolation trench is the highest.

4. The GaN-based multi-light-zone LED chip according to claim 1, wherein when the plurality of annular isolation trenches are provided, a light power density of a sub-light-emitting zone adjacent to an inner sidewall of innermost annular isolation trench is the highest.

5. The GaN-based multi-light-zone LED chip according to claim 4, wherein when the plurality of annular isolation trenches are provided, the light power density of the sub-light-emitting zone decreases gradually from inside to outside.

6. The GaN-based multi-light-zone LED chip according to claim 3 or claim 5, wherein the sub-light-emitting zone with the highest light power density among the sub-light-emitting zones has the light power density greater than 6 A/mm².

7. The GaN-based multi-light-zone LED chip according to claim 1, wherein the annular isolation trench is either a circular annular isolation trench or a polygonal annular isolation trench.

8. A light source module, comprising: a housing with an accommodation chamber, and the GaN-based multi-light-zone LED chip according to any one of claims 1 to 7.

9. The light source module according to claim 8, wherein the light source module further comprises a positive lens, the positive lens is disposed on the housing and a light emitted from the GaN-based multi-light-zone LED chip passes through the positive lens.

10. A preparing method for a GaN-based multi-light-zone LED chip according to any one of claims 1 to 7, wherein the preparing method comprises:
providing a substrate;
growing a GaN-based light-emitting body on the substrate;
providing an annular isolation trench in the GaN-based light-emitting body, wherein the annular isolation trench penetrates through a top surface and a bottom surface of the GaN-based light-emitting body, and when a plurality of annular isolation trenches are provided, contours of orthogonal projections onto the substrate gradually decrease in size and are nested from inside to outside.
